# EUROPÄISCHE PATENTSCHRIFT

(11) **EP 3 545 328 B1**
(45) Veröffentlichungstag und Bekanntmachung des Hinweises auf die Patenterteilung: **26.10.2022**
(21) Anmeldenummer: 17836002.0
(22) Anmeldetag: 16.11.2017
(51) Int. Cl.: H01M 10/04, H01M 10/48, G01R 35/00, B60R 16/033, G01R 19/00

(54) **ZWEISPANNUNGSBATTERIE MIT STROMSENSOREN UND KALIBRIERVERFAHREN HIERFÜR**
DUAL-VOLTAGE BATTERY HAVING CURRENT SENSORS AND CALIBRATION METHOD THEREFOR
BATTERIE À DEUX TENSIONS DOTÉE DE CAPTEURS DE COURANT ET PROCÉDÉ DE CALIBRAGE DESTINÉ À CELLE-CI

(30) Priorität: 22.11.2016 DE 102016122438
(43) Veröffentlichungstag der Anmeldung: 02.10.2019
(73) Patentinhaber: HELLA GmbH & Co. KGaA, 59552 Lippstadt (DE)
(72) Erfinder: KÖRNER, André, 59557 Lippstadt (DE); KAHNT, Sebastian, 91058 Erlangen (DE); KRIEGER, Jürgen, 97753 Karlstadt (DE)
(86) Internationale Anmeldenummer: PCT/EP2017/079477
(87) Internationale Veröffentlichungsnummer: WO 2018/095806

(56) Entgegenhaltungen:
- EP-A1- 2 385 575
- US-A1- 2007 107 767
- US-A1- 2014 015 488
- US-A1- 2015 364 797

## Beschreibung

Die Erfindung betrifft eine Zweispannungsbatterie für ein Fahrzeug mit den Merkmalen des Oberbegriffs des Anspruchs 1.

Ferner betrifft die Erfindung ein Kalibrierverfahren für eine Strommessung an einer Zweispannungsbatterie nach dem Oberbegriff des Anspruchs 14.

Eine gattungsgemäße Zweispannungsbatterie ist beispielsweise aus der DE 10 2013 113 182 A1 und der nachveröffentlichten deutschen Patentanmeldung 10 2016 116 972.2 bekannt. Jeweils ist eine Gruppe von Batteriezellblöcken vorgesehen, welche wechselweise parallel und seriell miteinander verschaltet werden zur Bereitstellung einer ersten niedrigen Spannung und einer zweiten höheren Spannung an den Anschlusspunkten der Zweispannungsbatterie.

Aus dem Dokument US 2014/ 0 015 488 A1 ist eine Zweispannungsbatterie mit den Merkmalen des Oberbegriffs des Anspruchs 1 bekannt. Aus dem Dokument ist auch ein Kalibrierverfahren für die offenbarte Zweispannungsbatterie bekannt.

Aufgabe der vorliegenden Erfindung ist es, eine Zweispannungsbatterie bereitzustellen, welche Stromsensoren zur Überwachung der Batterieströme aufweist, sowie ein Kalibrierverfahren für die Stromsensoren anzugeben.

Zur Lösung der Aufgabe ist die Erfindung in Verbindung mit dem Oberbegriff des Patentanspruchs 1 dadurch gekennzeichnet, dass mit den Leistungsschaltelementen die Batteriezellblöcke wahlweise seriell und/oder parallel verbindbar sind und dass wenigstens einzelnen Batteriezellblöcken ein Blockstromsensor mit einem Messwiderstand zugeordnet ist, welcher ausgebildet ist zum Messen eines Blockstroms durch den einen zugeordneten Batteriezellblock.

Während bei konventionellen Zweispannungsbatterien über einen Batteriesummenstromsensor der von der Batterie insgesamt bereitgestellte Batteriesummenstrom messtechnisch erfasst und überwacht werden kann, erlaubt es die erfindungsgemäße Zweispannungsbatterie in vorteilhafter Weise, durch das Vorsehen der Blockstromsensoren die Ströme durch die einzelnen Batteriezellblöcke separat zu erfassen und zu überwachen. Hierdurch erlangt man detaillierte Informationen über den Funktionszustand der einzelnen Batteriezellblöcke, ihre Belastung im Betrieb beziehungsweise den Ladezustand mit der Folge, dass die Zweispannungsbatterie zuverlässig überwacht und sicher betrieben werden kann. Beispielsweise kann ein kritischer Betriebszustand auf der Ebene der Batteriezellblöcke erkannt werden. Dabei kann durch die Bereitstellung einer geeigneten Verschaltung der Batteriezellblöcke eine sichere Versorgung der sicherheitskritischen elektrischen Verbraucher im Fahrzeug verbessert werden.

Nach einer bevorzugten Ausführungsform der Erfindung ist an einem Massepol der Zweispannungsbatterie ein Batteriesummenstromsensor vorgesehen, welcher ausgebildet ist zum Messen eines Batteriesummenstroms der Zweispannungsbatterie. Der Batteriesummenstrom ist hierbei definiert als die Summe der Blockströme, das heißt die Summe der Ströme durch die Batteriezellblöcke. Vorteilhaft besteht hierdurch die Möglichkeit einer redundanten Messung der Ströme in der Batterie und einer Überprüfung der Funktion der Stromsensorik. Die Anordnung des Batteriesummenstromsensors an dem Massepol bietet den Vorteil einer einfacheren Strommessung und Auswertung.

Alternativ kann der Batteriesummenstromsensor jedoch auch an einem oder mehreren Anschlusspunkten der Zweispannungsbatterie vorgesehen sein.

Nach einer Weiterbildung der Erfindung ist vorgesehen, dass die Messgenauigkeit des Batteriestromsensors größer ist als eine Messgenauigkeit der Blockstromsensoren. Vorteilhaft können durch das Vorsehen des Batteriesummenstromsensors mit der entsprechend großen Messgenauigkeit die Messgenauigkeit der Blockstromsensoren reduziert und kostengünstige Blockstromsensoren verbaut werden. Es reduziert sich dann der Kostenaufwand für die Zweispannungsbatterie insgesamt, wobei der Batteriesummenstromsensor zur Überwachung und insbesondere zur Kalibrierung der Blockstromsensoren vorgesehen wird. Eine negative Beeinflussung der Qualität der Überwachung der Batteriezellblöcke kann insofern vermieden werden.

Nach einer Weiterbildung der Erfindung ist der Blockstromsensor in einer Zellüberwachung für die Batteriezellen integriert vorgesehen, wobei ein Spannungsabfall an dem Messwiderstand des Blockstromsensors und eine Spannung der einzelnen Batteriezellen der Zellüberwachung zugeführt werden. Die Integration der Blockstromsensorik in die Zellüberwachung für die Batteriezellen des Batteriezellblocks erlaubt eine funktional integrierte und kostengünstige Möglichkeit zur Realisierung der Blockstrommessung. Insbesondere besteht die Möglichkeit, die Zellüberwachung vorzukonfigurieren und mit einer geringen Teileanzahl und einer vergleichsweise einfachen Montage die Kosten für die Zweispannungsbatterie weiter zu senken.

Nach einer Weiterbildung der Erfindung werden die Spannungen an den einzelnen Batteriezellen des Batteriezellblocks und der Spannungsabfall über den Messwiderstand des Blockstromsensors einer Sample-and-Hold-Schaltung zugeführt. Vorteilhaft können hierdurch der Strom und die Spannung gleichzeitig gemessen und die Sensorik beziehungsweise Überwachung verbessert werden.

Nach einer Weiterbildung der Erfindung ist der Messwiderstand für den Blockstromsensor so bemessen, dass ein Spannungsabfall über den Messwiderstand um den Faktor 10 oder mehr kleiner ist als eine größte Spannung der einzelnen Batteriezellen des dem Blockstromsensor zugeordneten Batteriezellblocks. Vorteilhaft kann die Messung hierdurch besonders genau durchgeführt und einer unzulässigen Beeinflussung der Funktion der Zweispannungsbatterie entgegengewirkt werden.

Nach einer Weiterbildung der Erfindung dient ein Verbindungsleiter für die Batteriezellblöcke der Zweispannungsbatterie oder ein interner Widerstand der Leistungsschaltelemente als Messwiderstand für den Blockstromsensor. Vorteilhaft ergibt sich so eine besonders kostengünstige Ausführung der erfindungsgemäßen Zweispannungsbatterie. Beispielsweise kann dem Messwiderstand und insbesondere dem Verbindungsleiter ein Temperatursensor zugeordnet sein, über den ein Einfluss der Temperatur auf das Messergebnis erfasst und im Weiteren der Einfluss der Temperatur herausgerechnet werden kann.

Zur Lösung der Aufgabe weist die Erfindung die Merkmale des unabhängigen Patentanspruchs 14 auf. Das erfindungsgemäße Kalibrierverfahren für eine Zweispannungsbatterie umfassend eine Mehrzahl von Batteriezellblöcken, umfassend Leistungsschaltelemente zum wechselweisen seriellen und/oder parallelen Verbinden der Batteriezellblöcke derart, dass in einer ersten Verbindungsanordnung mindestens einzelne Batteriezellblöcke parallel verschaltet werden und eine erste Spannung bereitgestellt wird und dass in einer zweiten Verbindungsanordnung eine Gruppe von Batteriezellblöcken seriell verbunden wird und eine zweite Spannung bereitgestellt wird, umfassend einen Blockstromsensor zum Messen eines Blockstroms durch einen der Batteriezellblöcke und umfassend einen Batteriesummenstromsensor, mit dem der Batteriesummenstrom durch die Zweispannungsbatterie gemessen wird, sieht insofern vor, dass in einem Kalibrierbetriebsmodus der Zweispannungsbatterie wenigstens ein Verbraucher von der Zweispannungsbatterie mit Energie versorgt wird, dass alle dem Blockstromsensor nicht zugeordneten Batteriezellblöcke mittels der Leistungsschaltelemente getrennt werden, dass dann der Blockstrom und der Batteriesummenstrom gemessen werden und dass der Blockstromsensor anhand eines Messwerts des Batteriestromsensors kalibriert wird.

Der besondere Vorteil der Erfindung besteht darin, dass in dem Kalibrierbetriebsmodus der Zweispannungsbatterie von dem Blockstromsensor und dem Batteriesummenstromsensor der gleiche Strom gemessen wird und insofern das gleiche Messergebnis ermittelt werden muss. Sofern es Abweichungen zwischen den Messergebnissen gibt, kann die Kenntnis über die physikalischen Zusammenhänge, nämlich das Wissen über die Identität der gemessenen Ströme, genutzt werden zur Kalibrierung der Sensoren. Insbesondere kann der Batteriesummenstromsensor mit einer großen Messgenauigkeit vorgesehen werden. Das Messergebnis, welches der Batteriesummenstromsensor liefert, kann dann genutzt werden zur Kalibrierung eines kostengünstigen und weniger genau messenden Blockstromsensors. Da in einer bevorzugten Konfiguration der erfindungsgemäßen Zweispannungsbatterie jedem Batteriezellblock ein Blockstromsensor zugeordnet ist, kann bei der Verwendung des erfindungsgemäßen Kalibrierverfahrens und einer sequentiellen, bedarfsabhängigen und/oder zyklischen Durchführung der Kalibrierung für die Blockstromsensoren die fehlende Genauigkeit der Messung korrigiert werden. Für die Blockstromsensoren können insofern weniger genaue und kostengünstige Stromsensoren vorgesehen werden. Beispielsweise können günstige Stromsensoren auf SMD-Shunt-Basis für die Blockstromsensoren zur Anwendung kommen. Für den Batteriesummenstromsensor können demgegenüber ein hochgenauer Shunt und ein ASIC verwendet werden, wobei eine Entkopplung der Signale durch Impedanzwandler realisiert werden kann. Der ASIC des Batteriesummenstromsensors kann für die Blockstromsensoren durch günstige Standard-Operationsverstärker ersetzt werden.

Nach einer bevorzugten Ausführungsform der Erfindung wird in dem Kalibrierbetriebsmodus der Zweispannungsbatterie temporär ein zusätzlicher elektrischer Verbraucher aktiviert. Während der zusätzliche elektrische Verbraucher aktiviert, das heißt zugeschaltet ist, werden der Blockstrom durch den Batteriezellblock und der Batteriesummenstrom erneut gemessen. Für die Kalibrierung der Blockstromsensoren ist dann ein zusätzlicher Messpunkt bekannt. Die Kalibrierung kann insofern besonders genau durchgeführt werden.

Nach einer Weiterbildung der Erfindung erfolgt eine 0 Ampere-Kalibrierung für den Blockstromsensor beispielsweise für einen getrennten Batteriezellblock, durch den kein Strom fließt. Die 0 Ampere-Kalibrierung kann beispielsweise für einen parallel verschalteten Batteriezellblock durchgeführt werden, der für die Dauer der 0 Ampere-Kalibrierung temporär getrennt wird. Beispielsweise kann die 0 Ampere-Kalibrierung im laufenden Betrieb für einen Batteriezellblock durchgeführt werden, welcher zwischen der parallelen und der seriellen Konfiguration umgeschaltet wird, das heißt von der ersten Verbindungsanordnung in die zweite Verbindungsanordnung oder zurück. Während des Umschaltens ist der Batteriezellblock jedenfalls kurzfristig getrennt, sodass durch den Batteriezellblock kurzfristig kein Strom fließt. Vorteilhaft können durch die 0 Ampere-Kalibrierung eine zusätzliche Stützstelle für die Kalibrierung der Blockstromsensoren erfasst und/oder ein Nullpunktfehler ausgeglichen werden. Es gelingt insofern, die Genauigkeit des Kalibrierverfahrens weiter zu verbessern.

Aus den weiteren Unteransprüchen und der nachfolgenden Beschreibung sind weitere Vorteile, Merkmale und Einzelheiten der Erfindung zu entnehmen. Dort erwähnte Merkmale können jeweils einzeln für sich oder auch in beliebiger Kombination erfindungswesentlich sein. Erfindungsgemäß beschriebene Merkmale und Details der Zweispannungsbatterie gelten selbstverständlich auch im Zusammenhang mit dem erfindungsgemäßen Kalibrierverfahren und umgekehrt. So kann auf die Offenbarung zu den einzelnen Erfindungsaspekten stets wechselseitig Bezug genommen werden. Die Zeichnungen dienen lediglich beispielhaft der Klarstellung der Erfindung und haben keinen einschränkenden Charakter.

Anhand der beigefügten Zeichnungen wird die Erfindung nachfolgend näher erläutert. Es zeigen:
- Fig. 1: ein Prinzipschaltbild einer erfindungsgemäßen Zweispannungsbatterie in einer ersten Konfiguration,
- Fig. 2: ein Prinzipschaltbild der erfindungsgemäßen Zweispannungsbatterie in einer zweiten Konfiguration,
- Fig. 3: ein Prinzipschaltbild der erfindungsgemäßen Zweispannungsbatterie in einer dritten Konfiguration und
- Fig. 4: ein Prinzipschaltbild der erfindungsgemäßen Zweispannungsbatterie in einer vierten Konfiguration.

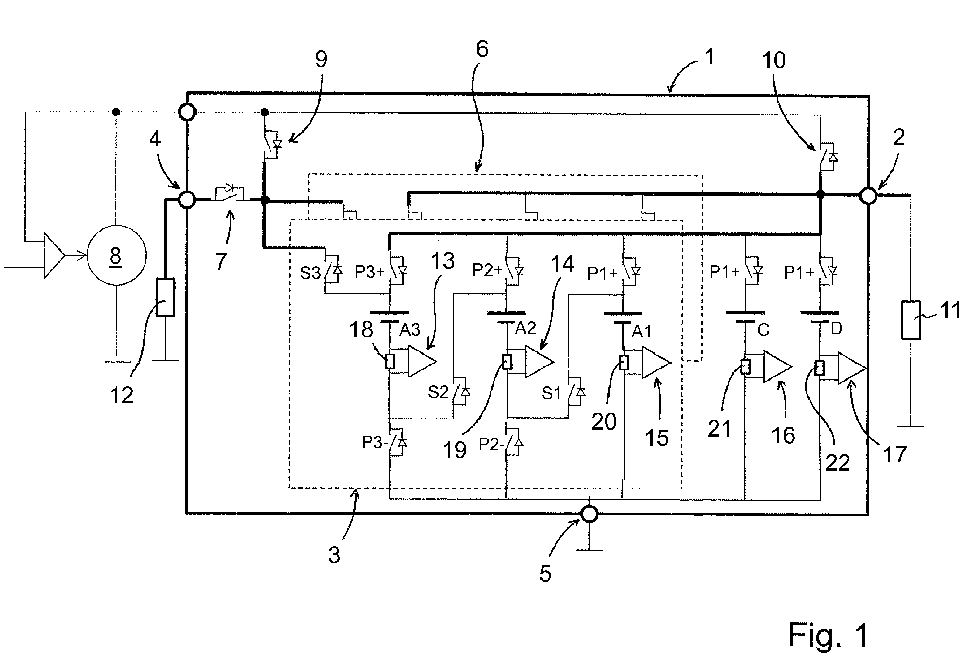

Eine erste Konfiguration einer erfindungsgemäßen Zweispannungsbatterie 1 nach Fig. 1 umfasst insgesamt acht bevorzugt baugleiche Batteriezellblöcke, von denen drei Batteriezellblöcke A1, A2, A3 eine erste Gruppe 3 von Batteriezellblöcken und noch einmal drei in der Fig. 1 von der ersten Gruppe 3 verdeckte Batteriezellblöcke eine zweite Gruppe 6 von Batteriezellblöcken bilden. Zu der ersten Gruppe 3 und der zweiten Gruppe 6 von Batteriezellblöcken sind zwei weitere Batteriezellblöcke C, D parallel verschaltet. Die weiteren Batteriezellblöcke C, D sind zueinander parallel und über ein erstes Leistungsschaltelement P1+ mit einem ersten Anschlusspunkt 2 der Zweispannungsbatterie 1 trennbar verbunden. Die drei Batteriezellblöcke A1, A2, A3 der ersten Gruppe 3 von Batteriezellblöcken sind über das erste Leistungsschaltelement P1 + sowie weitere Leistungsschaltelemente P2+, P2-, P3+, P3-, S1, S2, S3 in einer ersten Verbindungsanordnung zueinander parallel verschaltet und mit dem ersten Anschlusspunkt 2 der Zweispannungsbatterie 1 verbunden oder in einer zweiten Verbindungsanordnung der Zweispannungsbatterie 1 seriell verschaltet. In der seriellen Verschaltung der Batteriezellblöcke A1, A2, A3 der ersten Gruppe 3 ist über die Batteriezellblöcke A1, A2, A3 an einem zweiten Anschlusspunkt 4 der Zweispannungsbatterie 1 eine zweite, höhere Spannung bereitgestellt. Die an dem ersten Anschlusspunkt 2 bereitgestellte erste Spannung und die an dem zweiten Anschlusspunkt 4 bereitgestellte höhere zweite Spannung beziehen sich jeweils auf einen gemeinsamen Massepunkt 5 der Zweispannungsbatterie 1.

Neben der ersten Gruppe 3 von Batteriezellblöcken A1, A2, A3 ist die zweite Gruppe 6 von Batteriezellblöcken vorgesehen. Die zweite Gruppe 6 umfasst wie die erste Gruppe 3 drei Batteriezellblöcke. Der Aufbau der zweiten Gruppe 6 von Batteriezellblöcken ist analog zum Aufbau der ersten Gruppe 3 von Batteriezellblöcken A1, A2, A3. Insbesondere sieht auch die zweite Gruppe 6 von Batteriezellblöcken Leistungsschaltelemente zum wahlweisen parallelen und/oder seriellen Verbinden der Batteriezellblöcke vor. Insofern kann mittels der Batteriezellblöcke der zweiten Gruppe 6 abhängig von der Verbindungsanordnung der Batteriezellblöcke an dem ersten Anschlusspunkt 2 und/oder dem zweiten Anschlusspunkt 4 der Zweispannungsbatterie 1 die erste Spannung und/oder die zweite Spannung bereitgestellt werden. Zudem ist in Bezug auf die an dem zweiten Anschlusspunkt 4 bereitgestellte zweite Spannung ein Schaltelement 7 vorgesehen, welches in der zweiten Verbindungsanordnung geschlossen und in der ersten Verbindungsanordnung geöffnet ist.

Der Zweispannungsbatterie 1 ist des Weiteren beispielhaft ein Starter-Generator 8 zugeordnet, über den die Batteriezellen der Batteriezellblöcke A1, A2, A3, C, D gespeist werden können. Über den Starter-Generator 8 kann eine Energierückgewinnung realisiert werden. Insbesondere kann im Rahmen der Energierückgewinnung Bremsenergie in elektrische Energie gewandelt und in der Zweispannungsbatterie 1 gespeichert werden. Abhängig von der Konfiguration der Zweispannungsbatterie 1 kann der Statorgenerator 8 über weitere Schaltelemente 9, 10 spannungsabhängig bei der ersten Spannung und/oder bei der zweiten Spannung verbunden werden.

Über die Zweispannungsbatterie 1 werden elektrische Verbraucher 11, 12 im Bordnetz des Fahrzeugs an der ersten Spannung und/oder an der zweiten Spannung elektrisch versorgt. Die Versorgung der an der ersten Spannung betriebenen elektrischen Verbraucher 11 erfolgt insofern über den ersten Anschlusspunkt 2 der Zweispannungsbatterie 1 und die Versorgung der elektrischen Verbraucher 12 an der zweiten Spannung über den zweiten Anschlusspunkt 4 der Zweispannungsbatterie 1.

Den einzelnen Batteriezellblöcken A1, A2, A3, C, D der Zweispannungsbatterie 1 sind zur Bestimmung der Blockströme Blockstromsensoren 13, 14, 15, 16, 17 zugeordnet. Jeder Blockstromsensor 13, 14, 15, 16, 17 sieht hierbei einen Messwiderstand 18, 19, 20, 21, 22 vor, an dem der Blockstrom gemessen wird. Die Messwiderstände 18, 19, 20, 21, 22 sind dabei in Reihe verschaltet zu den Batteriezellblöcken A1, A2, A3, C, D. Durch die Erfassung der Blockströme für die einzelnen Batteriezellblöcke A1, A2, A3, C, D kann während des Betriebs der Ladungszustand für jeden Batteriezellblock A1, A2, A3, C, D bestimmt werden, sodass einer Überladung beziehungsweise Unterladung der einzelnen Batteriezellblöcke A1, A2, A3, C, D entgegengewirkt werden kann. Zusätzlich ist es möglich, die Ladung für alle Batteriezellblöcke A1, A2, A3, C, D auf einem ungefähr gleichen Niveau zu halten. Es gelingt insofern erfindungsgemäß, einem sehr unterschiedlichen Ladungszustand der Batteriezellblöcke A1, A2, A3, C, D entgegenzuwirken.

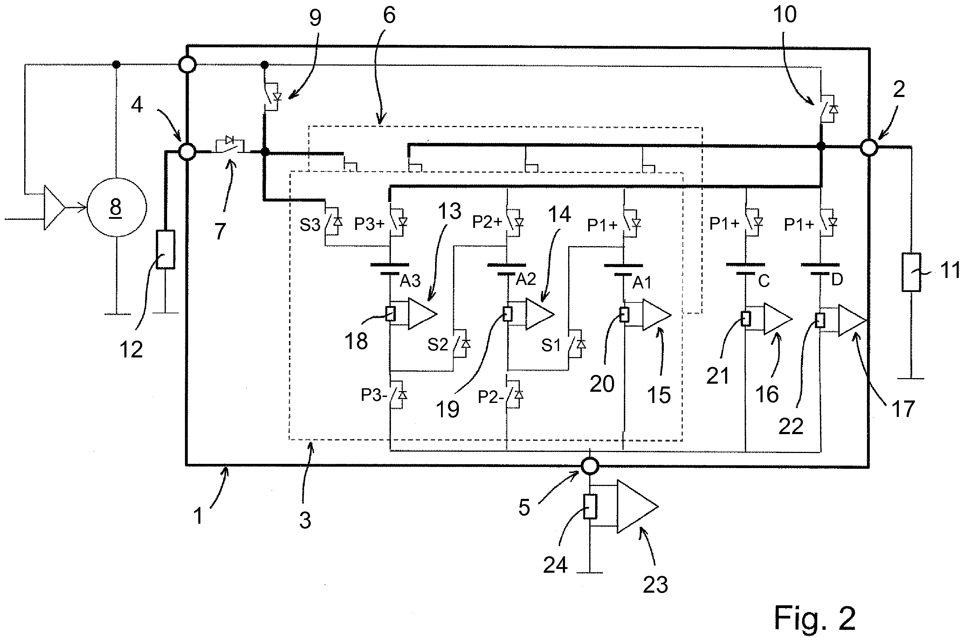

In einer zweiten Konfiguration der erfindungsgemäßen Zweispannungsbatterie 1 nach Fig. 2 ist dem Massepol 5 zusätzlich ein Batteriesummenstromsensor 23 mit einem Messwiderstand 24 zugeordnet. Über den Batteriesummenstromsensor 23 kann der Batteriesummenstrom zusätzlich zu den Blockströmen bestimmt werden. Ansonsten verläuft die Konfiguration der Zweispannungsbatterie 1 unverändert.

Vorteilhaft kann durch das Vorsehen des zusätzlichen Batteriesummenstromsensors 23 eine Kostenreduzierung für die Zweispannungsbatterie 1 insgesamt erreicht werden, wenn der Batteriesummenstromsensor 23 eine hohe Messgenauigkeit aufweist und die Blockstromsensoren 13, 14, 15, 16, 17 mit einer vergleichsweisen geringen Messgenauigkeit kostengünstig realisiert werden. Beispielsweise kann der Messwiderstand 24 des Batteriesummenstromsensors 23 hochgenau ausgeführt sein und ein ASIC vorgesehen werden. Demgegenüber können die Blockstromsensoren 13, 14, 15, 16, 17 auf SMD-Shunt-Basis realisiert und anstelle des ASIC kostengünstige Standard-Operationsverstärker vorgesehen werden. Insofern bedarf es nur eines hochgenauen Stromsensors 23 und einer Mehrzahl von kostengünstigen, weniger genauen Blockstromsensoren 13, 14, 15, 16, 17.

Eine gleichwohl zuverlässige Überwachung der Zweispannungsbatterie 1 wird durch eine wenigstens einmalige und bevorzugt wiederholt durchgeführte Kalibrierung der Blockstromsensoren 13, 14, 15, 16, 17 realisiert. Hierbei wird in einem Kalibrierbetriebsmodus der Zweispannungsbatterie 1 der elektrische Verbraucher 11 von der Zweispannungsbatterie 1 mit elektrischer Energie versorgt. Es wird zur Versorgung des elektrischen Verbrauchers 11 zunächst beispielsweise ein erster weiterer Batteriezellblock C der Zweispannungsbatterie 1 verbunden, während alle anderen Batteriezellblöcke A1, A2, A3, D getrennt werden. In der Schaltungsanordnung wird der von dem Batteriesummenstromsensor 23 gemessene Batteriesummenstrom allein von dem ersten weiteren Batteriezellblock C bereitgestellt mit der Folge, dass ein von dem weniger genau arbeitenden, dem ersten weiteren Batteriezellblock C zugeordneten Blockstromsensor 16 ermittelter Blockstrom dem Batteriesummenstrom entsprechen muss. So es hier zu einer Abweichung in den Messergebnissen kommt, wird der Blockstromsensor 16, welcher dem ersten weiteren Batteriezellblock C zugeordnet ist, anhand des Messwerts für den hochgenauen Batteriesummenstromsensor 23 kalibriert.

Nach der Kalibrierung des dem ersten weiteren Batteriezellblock C zugeordneten Blockstromsensors 16 kann sequentiell die Kalibrierung der weiteren Blockstromsensoren 13, 14, 15, 17 in analoger Weise durchgeführt werden. Die Kalibrierung kann beispielsweise durchgeführt werden, wenn das Fahrzeug abgestellt ist.

Eine Verbesserung der Kalibrierung der Blockstromsensoren 13, 14, 15, 16, 17 kann erreicht werden, wenn ein zusätzlicher elektrischer Verbraucher jedenfalls temporär aktiviert wird, während die Blockstromsensoren 13, 14, 15, 16, 17 kalibriert werden. Es kann sodann ein zusätzlicher Stützpunkt für die Kalibrierung der Blockstromsensoren 13, 14, 15, 16, 17 ermittelt werden.

Eine 0 Ampere-Kalibrierung der Blockstromsensoren 13, 14, 15, 16, 17 kann beispielsweise durchgeführt werden, wenn ein ausgewählter Batteriezellblock A1, A2, A3, C, D jedenfalls temporär getrennt ist. In diesem Trennungsbetriebszustand fließt kein Blockstrom. Eine Kalibrierung der Blockstromsensoren 13, 14, 15, 16, 17 für den 0 Ampere-Zustand kann insofern zuverlässig durchgeführt werden. Die Trennung des Batteriezellblocks A1, A2, A3, C, D für die 0 Ampere-Kalibrierung kann beispielsweise während des laufenden Betriebs erfolgen für einen parallel verschalteten Batteriezellblock A1, A2, A3, C, D, wenn dieser für die Dauer der 0 Ampere-Kalibrierung temporär getrennt wird. Ebenfalls kann die 0 Ampere-Kalibrierung durchgeführt werden, wenn während des laufenden Betriebs ein Batteriezellblock A1, A2, A3, C, D von der seriellen in die parallele Konfiguration oder zurück verschaltet wird. Beim Ändern der Konfiguration ist der Batteriezellblock A1, A2, A3, C, D jedenfalls temporär getrennt. Während der temporären Trennung kann die 0 Ampere-Kalibrierung für den Blockstromsensor 13, 14, 15, 16, 17 durchgeführt werden.

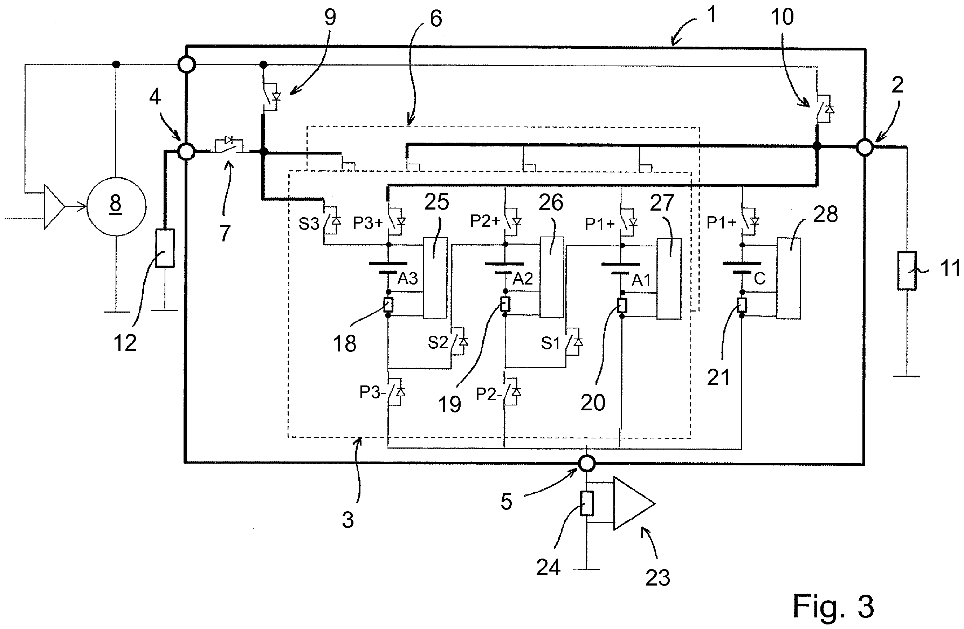

Nach einer dritten Konfiguration der erfindungsgemäßen Zweispannungsbatterie 1 gemäß Fig. 3 ist vorgesehen, dass die Messung des Blockstroms funktional und/oder räumlich integriert in eine Zellüberwachung 25, 26, 27, 28 integriert erfolgt. Die Zellüberwachung 25, 26, 27, 28 dient dazu, die Spannung für jede einzelne Batteriezelle der Batteriezellblöcke A1, A2, A3, C zu ermitteln. Zusätzlich wird ein Spannungsabfall über den Messwiderstand 18, 19, 20, 21 ermittelt zur Bestimmung der Blockströme. Beispielsweise kann die Zellüberwachung 25, 26, 27, 28 als eine Sample-and-Hold-Schaltung realisiert sein, mit der zeitgleich die Spannungen und Ströme bestimmt werden können. Eine Größe des Messwiderstands 18, 19, 20, 21 ist bevorzugt um eine Größenordnung kleiner als die größte Spannung einer Batteriezelle der einzelnen Batteriezellblöcke A1, A2, A3, C, D.

Lediglich exemplarisch ist in der dritten Konfiguration der Zweispannungsbatterie 1 auf einen weiteren, parallel verschalteten Batteriezellblock verzichtet worden. Grundsätzlich ist die Realisierung der erfindungsgemäßen Zweispannungsbatterie 1 und die Durchführung des erfindungsgemäßen Kalibrierverfahrens nicht auf das Vorsehen von sieben oder acht Batteriezellblöcken A1, A2, A3, C, D beschränkt. Es ist insofern für die Erfindung wesentlich, dass wenigstens eine Gruppe 3, 6 von Batteriezellblöcken A1, A2, A3 variabel verschaltet werden kann zur Bereitstellung der ersten Spannung und/oder der zweiten Spannung und dass jedenfalls für einzelne und bevorzugt für alle Batteriezellblöcke A1, A2, A3, C, D die Blockströme erfasst und gegebenenfalls eine Kalibrierung der Blockstromsensoren 13, 14, 15, 16, 17 anhand des Batteriesummenstroms erfolgen kann. Es kann beispielsweise auf die weiteren Batteriezellblöcke C, D verzichtet sein.

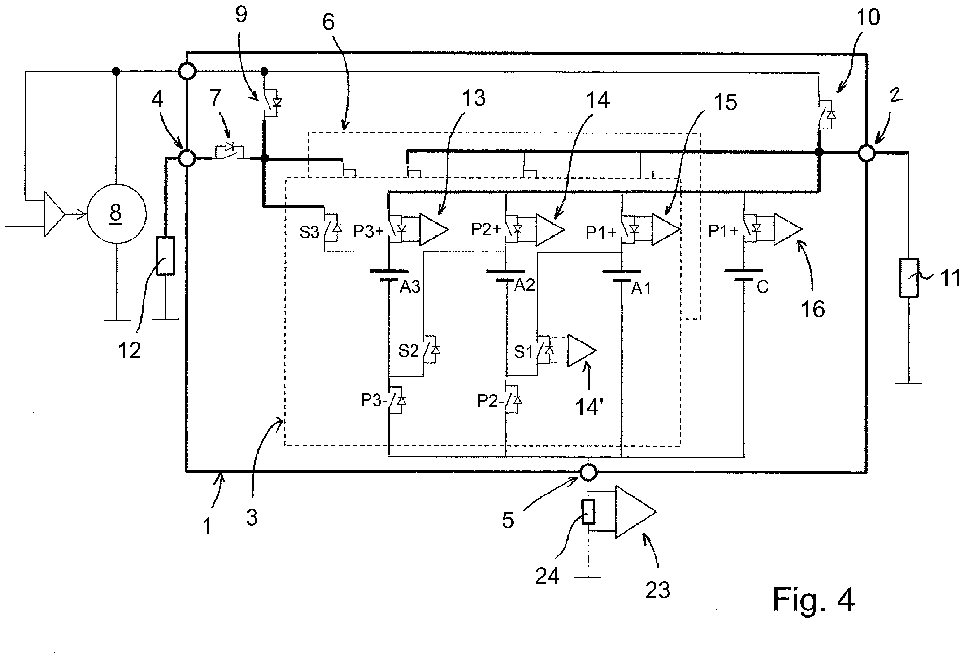

Fig. 4 zeigt eine vierte Konfiguration der erfindungsgemäßen Zweispannungsbatterie 1, bei der auf die Verwendung zusätzlicher Messwiderstände verzichtet wird. Die Blockstromsensoren 13, 14, 14', 15, 16 sind insofern unmittelbar den zugeordneten Leistungsschaltelementen P1+, P2+, P3+, P2-, P3-, S1 zugeordnet. In den Leistungsschaltelementen P1+, P2+, P3+, P2-, P3-, S1 vorgesehene Widerstände werden hier zugleich als Messwiderstand für die Blockstrommessung vorgesehen. Die vierte Konfiguration kann insofern besonders kompakt und kostengünstig realisiert sein.

Nach einer alternativen, nicht dargestellten Konfiguration der erfindungsgemäßen Zweispannungsbatterie 1 kann auf separate Messwiderstände auch dann verzichtet werden, wenn alternativ die zwischen den Batteriezellblöcken A1, A2, A3, C, D vorgesehenen Verbindungsleiter zur Strommessung verwendet werden. Die Verbindungsleiter, welche normalerweise aus Kupfer oder einer Kupferlegierung bestehen, können zur Kompensation des Kupfer-Temperaturkoeffizienten einen zugeordneten Temperatursensor aufweisen, durch den Temperatureffekte in der Messung ausgeglichen werden können. Alternativ kann vorgesehen sein, dass die Verbindungsleiter aus einem anderen Werkstoff als Kupfer beziehungsweise einer Kupferlegierung hergestellt sind, welcher einen größeren Widerstand und/oder eine verbesserte Temperaturstabilität aufweist. Beispielsweise können Messing, Bronze, Stahl oder entsprechende Legierungen verwendet werden.

Gleiche Bauteile und Bauteilfunktionen sind durch gleiche Bezugszeichen gekennzeichnet.

### Bezugszeichenliste

- 1: Zweispannungsbatterie
- 2: erster Anschlusspunkt
- 3: erste Gruppe von Batteriezellblöcken
- 4: zweiter Anschlusspunkt
- 5: Massepunkt
- 6: zweite Gruppe von Batteriezellblöcken
- 7: Schaltelement
- 8: Starter-Generator
- 9: Schaltelement
- 10: Schaltelement
- 11: Verbraucher
- 12: Verbraucher
- 13: Blockstromsensor
- 14, 14': Blockstromsensor
- 15: Blockstromsensor
- 16: Blockstromsensor
- 17: Blockstromsensor
- 18: Messwiderstand
- 19: Messwiderstand
- 20: Messwiderstand
- 21: Messwiderstand
- 22: Messwiderstand
- 23: Batteriesummenstromsensor
- 24: Messwiderstand
- 25: Zellüberwachung
- 26: Zellüberwachung
- 27: Zellüberwachung
- 28: Zellüberwachung
- A1: Batteriezellblock
- A2: Batteriezellblock
- A3: Batteriezellblock
- C: weiterer Batteriezellblock
- D: weiterer Batteriezellblock
- P1+: Leistungsschaltelement
- P2+: Leistungsschaltelement
- P3+: Leistungsschaltelement
- P2-: Leistungsschaltelement
- P3-: Leistungsschaltelement
- S1: Leistungsschaltelement
- S2: Leistungsschaltelement
- S3: Leistungsschaltelement

## Patentansprüche

1. Zweispannungsbatterie (1) für ein Fahrzeug umfassend eine Mehrzahl von Batteriezellen, wobei jeweils eine Gruppe von Batteriezellen zu einer Anzahl von Batteriezellblöcken (A1, A2, A3) verbunden ist, und umfassend eine Batterieelektronik mit einer Mehrzahl von Leistungsschaltelementen (P1+, P2+, P3+, P2-, P3-, S1, S2, S3), wobei in einer ersten Verbindungsanordnung der Batteriezellblöcke (A1, A2, A3) eine erste Spannung und wobei in einer zweiten Verbindungsanordnung der Batteriezellblöcke (A1, A2, A3) eine zweite Spannung bereitgestellt ist,
**dadurch gekennzeichnet,**
**dass** mit den Leistungsschaltelementen die Batteriezellblöcke (A1, A2, A3) wahlweise seriell und/oder parallel verbindbar sind und dass wenigstens einzelnen Batteriezellblöcken (A1, A2, A3) ein Blockstromsensor (13, 14, 14', 15, 16, 17) mit einem Messwiderstand (18, 19, 20, 21, 22) zugeordnet ist, welcher ausgebildet ist zum Messen eines Blockstroms durch den einen zugeordneten Batteriezellblock (A1, A2, A3).

2. Zweispannungsbatterie (1) nach Anspruch 1, **dadurch gekennzeichnet, dass** an einem Massepol (5) der Zweispannungsbatterie (1) ein Batteriesummenstromsensor (23) vorgesehen ist, welcher ausgebildet ist zum Messen eines Batteriesummenstroms der Zweispannungsbatterie (1).

3. Zweispannungsbatterie (1) nach Anspruch 1, **dadurch gekennzeichnet, dass** an einem oder mehreren Anschlusspunkten (2, 4) der Zweispannungsbatterie (1) ein Batteriesummenstromsensor (23) vorgesehen ist, welcher ausgebildet ist zum Messen eines Batteriesummenstroms der Zweispannungsbatterie (1).

4. Zweispannungsbatterie (1) nach Anspruch 2 oder 3, **dadurch gekennzeichnet, dass** eine Messgenauigkeit des Batteriesummenstromsensors (23) größer ist als eine Messgenauigkeit von wenigstens einem der Blockstromsensoren (13, 14, 14', 15, 16, 17).

5. Zweispannungsbatterie (1) nach einem der Ansprüche 1 bis 4, **dadurch gekennzeichnet, dass** alle Blockstromsensoren (13, 14, 14', 15, 16, 17) baugleich ausgeführt sind.

6. Zweispannungsbatterie (1) nach einem der Ansprüche 1 bis 5, **dadurch gekennzeichnet, dass** der Blockstromsensor (13, 14, 14', 15, 16, 17) jedenfalls teilweise in einer Zellüberwachung (25, 26, 27, 28) für die Batteriezellen des dem Blockstromsensor zugeordneten Batteriezellblocks (A1, A2, A3) integriert vorgesehen ist, wobei ein Spannungsabfall an dem Messwiderstand (18, 19, 20, 21) der Zellüberwachung (25, 26, 27, 28) zugeführt ist.

7. Zweispannungsbatterie (1) nach Anspruch 6, **dadurch gekennzeichnet, dass** der Messwiderstand (18, 19, 20, 21) so dimensioniert ist, dass der Spannungsabfall an dem Messwiderstand (18, 19, 20, 21) um wenigstens den Faktor 10 und bevorzugt um den Faktor 100 oder mehr kleiner ist als eine größte Spannung der einzelnen Batteriezellen des Batteriezellblocks (A1, A2, A3).

8. Zweispannungsbatterie (1) nach Anspruch 6 oder 7, **dadurch gekennzeichnet, dass** die Spannung der einzelnen Batteriezellen des Batteriezellblocks (A1, A2, A3) und der Spannungsabfall über den Messwiderstand (18, 19, 20, 21) des dem Batteriezellblocks (A1, A2, A3) zugeordneten Blockstromsensor für die gleichzeitige Messung von Spannung und Strom einer Sample-and-Hold-Schaltung zugeführt sind.

9. Zweispannungsbatterie (1) nach einem der Ansprüche 1 bis 8, **dadurch gekennzeichnet, dass** ein Verbindungsleiter für die Batteriezellblöcke (A1, A2, A3) oder ein Teil des Verbindungsleiters als Messwiderstand (18, 19, 20, 21, 22) für den Blockstromsensor (13, 14, 14', 15, 16, 17) dient.

10. Zweispannungsbatterie (1) nach Anspruch 9, **dadurch gekennzeichnet, dass** dem Verbindungsleiter oder dem Teil desselben ein Temperatursensor zugeordnet ist.

11. Zweispannungsbatterie (1) nach einem der Ansprüche 1 bis 10, **dadurch gekennzeichnet, dass** ein interner Widerstand des Leistungsschaltelements (P1+, P2+, P3+, P2-, P3-, S1) als Messwiderstand für den Blockstromsensor (13, 14, 14', 15, 16, 17) vorgesehen ist.

12. Zweispannungsbatterie (1) nach einem der Ansprüche 1 bis 11, **dadurch gekennzeichnet, dass** jedem Batteriezellblock (A1, A2, A3) ein einzelner Blockstromsensor (13, 14, 14', 15, 16, 17) zugeordnet ist.

13. Zweispannungsbatterie (1) nach einem der Ansprüche 1 bis 12, **dadurch gekennzeichnet, dass** zu den wahlweise parallel und/oder in Reihe verschaltbaren Batteriezellblöcken (A1, A2, A3) weitere Batteriezellblöcke (C, D) parallel angeordnet sind, wobei von den weiteren Batteriezellblöcken (C, D) die erste Spannung bereitgestellt ist.

14. Kalibrierverfahren für eine Zweispannungsbatterie (1), insbesondere für eine Zweispannungsbatterie (1) nach einem der Ansprüche 1 bis 13, umfassend eine Mehrzahl von Batteriezellblöcken (A1, A2, A3), umfassend Leistungsschaltelemente (P1+, P2+, P3+, P2-, P3-, S1, S2, S3) und umfassend einen Batteriesummenstromsensor (23), mit dem der Batteriesummenstrom durch die Zweispannungsbatterie (1) gemessen wird,
**dadurch gekennzeichnet,**
**dass** die Batteriezellblöcke (A1, A2, A3) mit den Leistungsschaltelemente (P1 +, P2+, P3+, P2-, P3-, S1, S2, S3) seriell und/oder parallel derart verbunden werden können, dass in einer ersten Verbindungsanordnung jedenfalls einzelne Batteriezellblöcke (A1, A2, A3) parallel verschaltet werden und eine erste Spannung bereitgestellt wird und dass in einer zweiten Verbindungsanordnung eine Gruppe von Batteriezellblöcken (A1, A2, A3) seriell verbunden wird und eine zweite Spannung bereitgestellt wird,
**dass** die Zweispannungsbatterie einen Blockstromsensor (13, 14, 14', 15, 16, 17) zum Messen eines Blockstroms durch den dem Blockstromsensor (13, 14, 14', 15, 16, 17) zugeordneten Batteriezellblock (A1, A2, A3) aufweist, und dass in einem Kalibrierbetriebsmodus der Zweispannungsbatterie (1) wenigstens ein Verbraucher (11, 12) von der Zweispannungsbatterie (1) mit Energie versorgt wird, wobei alle dem Blockstromsensor (13, 14, 14', 15, 16, 17) nicht zugeordneten Batteriezellblöcke (A1, A2, A3) mittels der Leistungsschaltelemente (P1 +, P2+, P3+, P2-, P3-, S1, S2, S3) getrennt werden, wobei dann der Blockstrom und der Batteriesummenstrom gemessen werden und wobei der Blockstromsensor (13, 14, 14', 15, 16, 17) anhand eines Messwerts des Batteriesummenstroms (23) kalibriert wird.

15. Kalibrierverfahren nach Anspruch 14, **dadurch gekennzeichnet, dass** in dem Kalibrierbetriebsmodus temporär ein zusätzlicher elektrischer Verbraucher (11, 12) aktiviert wird und der Blockstrom und der Batteriesummenstrom erneut gemessen werden.

16. Kalibrierverfahren nach Anspruch 14 oder 15, **dadurch gekennzeichnet, dass** in einem Trennbetriebszustand der Zweispannungsbatterie (1), in dem wenigstens ein Batteriezellblock (A1, A2, A3) nicht verbunden ist, für den wenigstens einen getrennten Batteriezellblock (A1, A2, A3) mittels des dem wenigstens einen getrennten Batteriezellblock (A1, A2, A3) zugeordneten Blockstromsensors (13, 14, 14', 15, 16, 17) eine 0 Ampere-Kalibrierung durchgeführt wird.

17. Kalibrierverfahren nach Anspruch 16, **dadurch gekennzeichnet, dass** die 0 Ampere-Kalibrierung während des laufenden Betriebs für einen parallel geschalteten Batteriezellblock (A1, A2, A3) durchgeführt wird, welcher für die Dauer der Messung temporär getrennt wird.

18. Kalibrierverfahren nach Anspruch 16 oder 17, **dadurch gekennzeichnet, dass** die 0 Ampere-Kalibrierung während des laufenden Betriebs für einen Batteriezellblock (A1, A2, A3) durchgeführt wird, welcher zwischen der seriellen und der parallelen Konfiguration umgeschaltet wird, wobei zwischen dem Umschalten der Batteriezellblock (A1, A2, A3) jedenfalls kurzfristig getrennt ist.

## Claims

1. Dual voltage battery (1) for a vehicle, comprising a plurality of battery cells, where in each case a group of battery cells are connected to a number of battery cell blocks (A1 A2, A3) and comprising battery electronics with a plurality of power switching elements (P1 +, P2+, P3+, P2-, P3-, S1, S2, S3), where in a first connection arrangement of the battery cell blocks (A1 A2, A3) a first voltage is provided and where in a second connection arrangement of the battery cell blocks (A1 A2, A3) a second voltage is provided,
**characterized in that**
the battery cell blocks (A1 A2, A3) can be connected to the power switching elements optionally in series and/or in parallel and a block current sensor (13, 14, 14', 15, 16, 17) with a measuring resistor (18, 19, 20, 21, 22) is allocated to at least individual battery cell blocks (A1 A2, A3), which measuring resistor is designed to measure block current through the one allocated battery cell block (A1 A2, A3).

2. Dual voltage battery (1) in accordance with claim 1, **characterized in that** a battery sum current sensor (23) is provided for at one earth pole (5) of the dual voltage battery (1), which sum current sensor is designed to measure a battery sum current of the dual voltage battery (1).

3. Dual voltage battery (1) in accordance with claim 1, **characterized in that** a battery sum current sensor (23) is provided for at one or several connection points (2, 4) of the dual voltage battery (1), which sum current sensor is designed to measure a battery sum current of the dual voltage battery (1).

4. Dual voltage battery (1) in accordance with claim 2 or 3, **characterized in that** a measurement accuracy of the battery sum current sensor (23) is greater than a measurement accuracy of at least one of the block current sensors (13, 14, 14', 15, 16, 17).

5. Dual voltage battery (1) in accordance with one of claims 1 through 4, **characterized in that** all block current sensors (13, 14, 14', 15, 16, 17) are identical in design.

6. Dual voltage battery (1) in accordance with one of claims 1 through 5, **characterized in that** the block current sensor (13, 14, 14', 15, 16, 17) is provided to be at any event partially integrated into a cell monitoring system (25, 26, 27, 28) for the battery cells of the battery cell block (A1, A2, A3) allocated to the block current sensor, where a voltage drop at the measuring resistor (18, 19, 20, 21) is directed to the cell monitoring system (25, 26, 27, 28).

7. Dual voltage battery (1) in accordance with claim 6, **characterized in that** the measuring resistor (18, 19, 20, 21) is dimensioned such that the voltage drop at the measuring resistor (18, 19, 20, 21) is smaller by at least the factor of 10 and preferentially by the factor of 100 or more than the largest voltage of the individual battery cells of the battery cell block (A1 A2, A3).

8. Dual voltage battery (1) in accordance with claim 6 or 7, **characterized in that** the voltage of the individual battery cells of the battery cell block (A1 A2, A3) and the voltage drop through the measuring resistor (18, 19, 20, 21) of the block current sensor allocated to the battery cell block (A1 A2, A3) are directed to a sample-and-hold circuit for simultaneous measurement of voltage and current.

9. Dual voltage battery (1) in accordance with one of claims 1 through 8, **characterized in that** a connection conductor for the battery cell blocks (A1 A2, A3) or a part of the connection conductor serves as a measuring resistor (18, 19, 20, 21, 22) for the block current sensor (13, 14, 14', 15, 16, 17).

10. Dual voltage battery (1) in accordance with claim 9, **characterized in that** a temperature sensor is allocated to the connection conductor or a part of the same.

11. Dual voltage battery (1) in accordance with claims 1 through 10, **characterized in that** an internal resistor of the power switching element (P1+, P2+, P3+, P2-, P3-, S1) is provided for as a measuring resistor for the block current sensor (13, 14, 14', 15, 16, 17).

12. Dual voltage battery (1) in accordance with one of claims 1 through 11, **characterized in that** an individual block current sensor (13, 14, 14', 15, 16, 17) is allocated to each battery cell block (A1 A2, A3).

13. Dual voltage battery (1) in accordance with one of claims 1 through 12, **characterized in that** further battery cell blocks (C, D) are arranged in parallel to the battery cell blocks (A1 A2, A3) that can be wired optionally in parallel and/or in series, where the first current is provided by the further battery cell blocks (C, D).

14. Calibration method for a dual voltage battery (1), in particular for a dual voltage battery (1) in accordance with one of claims 1 through 13, comprising a plurality of battery cell blocks (A1 A2, A3), comprising power switching elements (P1 +, P2+, P3+, P2-, P3-, S1, S2, S3) and comprising a battery current sensor (23) with which the battery sum current through the dual voltage battery (1) is measured,
**characterized in that**
the battery cell blocks (A1, A2, A3) can be connected in series and/or in parallel with the power switching elements (P1+, P2+, P3+, P2-, P3-, S1, S2, S3), **in that** in a first connection arrangement in any case individual battery cell blocks (A1, A2, A3) can be wired in parallel and a first current is provided and **in that** in a second connection arrangement a group of battery cell blocks (A1, A2, A3) are connected in series and a second current is provided, **in that** the dual voltage battery features a block current sensor (13, 14, 14', 15, 16, 17) to measure a block current through the battery cell block (A1, A2, A3) allocated to the block current sensor (13, 14, 14', 15, 16, 17) and **in that** in a calibration operating mode of the dual voltage battery (1) at least one consumer (11, 12) is provided with energy from the dual voltage battery (1), where all battery cell blocks (A1, A2, A3) not allocated to the block current sensor (13, 14, 14', 15, 16, 17) are isolated by means of the power switching elements (P1+, P2+, P3+, P2-, P3-, S1, S2, S3), where the block current and the block sum current are then measured and where the block current sensor (13, 14, 14', 15, 16, 17) is calibrated on the basis of a measured value of the battery sum current (23).

15. Calibration method in accordance with claim 14, **characterized in that** in the calibration operating mode an additional electrical consumer (11, 12) is temporarily activated and the battery sum current is measured again.

16. Calibration method in accordance with claim 14 or 15, **characterized in that** in an isolation operating state of the dual voltage battery (1) in which at least one battery cell block (A1 A2, A3) is not connected, a 0 ampere calibration is performed for the at least one isolated battery cell block (A1, A2, A3) by means of the block current sensor (13, 14, 14', 15, 16, 17) allocated to the at least one isolated battery cell block (A1 A2, A3).

17. Calibration method in accordance with claim 16, **characterized in that** the 0 ampere calibration is performed during ongoing operation for a battery cell block (A1 A2, A3) wired in parallel which is temporarily isolated for the duration of the measurement.

18. Calibration method in accordance with claim 16 or 17, **characterized in that** the 0 ampere calibration is performed during ongoing operation for a battery cell block (A1 A2, A3) which is switched between the series and the parallel configuration, where the battery cell block (A1 A2, A3) is at any event briefly isolated between the switchovers.

## Revendications

1. Batterie à deux tensions (1) pour un véhicule comprenant plusieurs cellules de batterie, un groupe de cellules de batterie étant respectivement relié à un certain nombre de blocs de cellules de batterie (A1, A2, A3) et comprenant un système électronique de batterie avec plusieurs éléments de commutation de puissance (P1 +, P2+, P3+, P2-, P3-, S1, S2, S3) dans lequel une première tension est fournie dans un premier agencement de connexion des blocs de cellules de batterie (A1, A2, A3) et dans lequel une deuxième tension est fournie dans un deuxième agencement de connexion des blocs de cellules de batterie (A1, A2, A3),
**caractérisé en ce que**
les blocs de cellules de batterie (A1, A2, A3) peuvent être reliés au choix en série et/ou en parallèle avec les éléments de commutation de puissance et **en ce qu'**un capteur de courant de bloc (13, 14, 14', 15, 16, 17) avec une résistance de mesure (18, 19, 20, 21, 22) est associé à au moins certains blocs de cellules de batterie (A1, A2, A3), celui-ci étant conçu pour mesurer un courant traversant un bloc de cellules de batterie (A1, A2, A3) associé.

2. Batterie à deux tensions (1) selon la revendication 1, **caractérisée en ce qu'**un capteur de courant total de batterie (23) est prévu sur un pôle de masse (5) de la batterie à deux tensions (1), celui-ci étant conçu pour mesurer un courant total de la batterie à deux tensions (1).

3. Batterie à deux tensions (1) selon la revendication 1, **caractérisée en ce qu'**un capteur de courant total de batterie (23) est prévu à un ou plusieurs points de connexion (2, 4) de la batterie à deux tensions (1), celui-ci étant conçu pour mesurer un courant total de batterie de la batterie à deux tensions (1).

4. Batterie à deux tensions (1) selon la revendication 2 ou 3, **caractérisée en ce qu'**une précision de mesure du capteur de courant total de batterie (23) est supérieure à une précision de mesure d'au moins un des capteurs de courant de bloc (13, 14, 14', 15, 16, 17).

5. Batterie à deux tensions (1) selon l'une des revendications 1 à 4, **caractérisée en ce que** tous les capteurs de courant de bloc (13, 14, 14', 15, 16, 17) sont de construction identique.

6. Batterie à deux tensions (1) selon l'une des revendications 1 à 5, **caractérisée en ce que** le capteur de courant de bloc (13, 14, 14', 15, 16, 17) est prévu comme étant au moins partiellement intégré dans une surveillance de cellule (25, 26, 27, 28) pour les cellules de batterie du bloc de cellules (A1, A2, A3) associé au capteur de courant de bloc, une chute de tension sur la résistance de mesure (18, 19, 20, 21) étant appliquée à la surveillance de cellule (25, 26, 27, 28).

7. Batterie à deux tensions (1) selon la revendication 6, **caractérisée en ce que** la résistance de mesure (18, 19, 20, 21) est dimensionnée de telle sorte que la chute de tension au niveau de la résistance de mesure (18, 19, 20, 21) est inférieure d'un facteur d'au moins 10, et de préférence d'un facteur de 100 ou plus, à une tension maximale des différentes cellules du bloc de cellules de batterie (A1, A2, A3).

8. Batterie à deux tensions (1) selon la revendication 6 ou 7, **caractérisée en ce que** la tension des différentes cellules de batterie du bloc de cellules de batterie (A1, A2, A3) et la chute de tension sont appliquées à un circuit échantillonneur-bloqueur via la résistance de mesure (18, 19, 20, 21) du capteur de courant de bloc associé au bloc de cellules de batterie (A1, A2, A3) pour la mesure simultanée de la tension et du courant.

9. Batterie à deux tensions (1) selon l'une des revendications 1 à 8, **caractérisée en ce qu'**un conducteur de liaison pour les blocs de cellules de batterie (A1, A2, A3) ou une partie du conducteur de liaison sert de résistance de mesure (18, 19, 20, 21, 22) pour le capteur de courant de bloc (13, 14, 14', 15, 16, 17).

10. Batterie à deux tensions (1) selon la revendication 9, **caractérisée en ce qu'**un capteur de température est affecté au conducteur de liaison ou à la partie correspondante de celui-ci.

11. Batterie à deux tensions (1) selon l'une des revendications 1 à 10, **caractérisée en ce qu'**une résistance interne de l'élément de commutation de puissance (P1 +, P2+, P3+, P2-, P3-, S1) est prévue comme résistance de mesure pour le capteur de courant de bloc (13, 14, 14', 15, 16, 17).

12. Batterie à deux tensions (1) selon l'une des revendications 1 à 11, **caractérisée en ce qu'**un capteur de courant de bloc individuel (13, 14, 14', 15, 16, 17) est associé à chaque bloc de cellules de batterie (A1, A2, A3).

13. Batterie à deux tensions (1) selon l'une des revendications 1 à 12, **caractérisée en ce que** d'autres blocs de cellules de batterie (C, D) sont disposés en parallèle avec les blocs de cellules de batterie (A1, A2, A3) lesquels peuvent être raccordés au choix en parallèle et/ou en série, la première tension étant fournie par les autres blocs de cellules de batterie (C, D).

14. Procédure de calibrage pour une batterie à deux tensions (1), en particulier pour une batterie à deux tensions (1) selon l'une des revendications 1 à 13, avec plusieurs blocs de cellules de batterie (A1, A2, A3) comprenant des éléments de commutation de puissance (P1 +, P2+, P3+, P2-, P3-, S1, S2, S3) et un capteur de courant total de batterie (23) avec lequel le courant total de batterie est mesuré dans la batterie à deux tensions (1),
**caractérisée en ce que**
les blocs de cellules de batterie (A1, A2, A3) peuvent être raccordés en série et/ou en parallèle avec les éléments de commutation de puissance (P1 +, P2+, P3+, P2-, P3-, S1, S2, S3) de telle sorte que, dans un premier agencement de connexion, certains blocs de cellules de batterie individuels (A1, A2, A3) sont connectés en parallèle et une première tension est fournie et que, dans un deuxième agencement de connexion, un groupe de blocs de cellules de batterie (A1, A2, A3) est connecté en série et une deuxième tension est fournie, **en ce que** la batterie à deux tensions comporte un capteur de courant de bloc (13, 14, 14', 15, 16, 17) pour mesurer un courant de bloc dans le bloc de cellules de batterie (A1, A2, A3) associé au capteur de courant de bloc (13, 14, 14', 15, 16, 17) et **en ce que**, lors du fonctionnement en mode calibrage de la batterie à deux tensions (1), au moins un consommateur (11, 12) est alimenté en énergie par la batterie à deux tensions (1), tous les blocs de cellules de batterie (A1, A2, A3) non associés au capteur de courant de bloc (13, 14, 14', 15, 16, 17) étant séparés au moyen des éléments de commutation de puissance (P1 +, P2+, P3+, P2-, P3-, S1, S2, S3), le courant de bloc et le courant total de la batterie étant alors mesurés et le capteur de courant de bloc (13, 14, 14', 15, 16, 17) étant étalonné à l'aide d'une valeur de mesure du courant total de la batterie (23).

15. Procédure de calibrage selon la revendication 14, **caractérisée en ce que**, en mode de fonctionnement calibrage, un consommateur électrique supplémentaire (11, 12) est temporairement activé et le courant de bloc et le courant total de batterie sont à nouveau mesurés.

16. Procédure de calibrage selon la revendication 14 ou 15, **caractérisée en ce que**, dans un état de service déconnecté de la batterie à deux tensions (1), dans lequel au moins un bloc de cellules de batterie (A1, A2, A3) n'est pas connecté, un calibrage à 0 ampère est effectué pour au moins un bloc de cellules de batterie déconnecté (A1, A2, A3) au moyen du capteur de courant de bloc (13, 14, 14', 15, 16, 17) associé au bloc de cellules de batterie déconnecté (A1, A2, A3).

17. Procédure de calibrage selon la revendication 16, **caractérisée en ce que** le calibrage à 0 ampère est réalisé pendant le fonctionnement pour un bloc de cellules de batterie (A1, A2, A3) monté en parallèle, celui-ci étant temporairement déconnecté pendant la durée de la mesure.

18. Procédure de calibrage selon la revendication 16 ou 17, **caractérisée en ce que** le calibrage 0 ampère est effectué pendant le fonctionnement pour un bloc de cellules de batterie (A1, A2, A3) commuté entre la configuration série et la configuration parallèle, le bloc de cellules de batterie (A1, A2, A3) étant temporairement déconnecté entre les opérations de commutation.
